## Europäisches Patentamt
## European Patent Office
## Office européen des brevets

(19)

(11) Veröffentlichungsnummer: **0 045 466**
A2

(12) **EUROPÄISCHE PATENTANMELDUNG**

(21) Anmeldenummer: 81105900.5

(22) Anmeldetag: 25.07.81

(51) Int. Cl.³: **H 05 K 3/10**

(30) Priorität: 04.08.80 DE 3029521

(43) Veröffentlichungstag der Anmeldung:
10.02.82 Patentblatt 82/6

(84) Benannte Vertragsstaaten:
AT BE CH FR GB IT LI LU NL SE

(71) Anmelder: Schmoock, Helmuth
Büchener Weg 121
D-2058 Lauenburg/Elbe(DE)

(72) Erfinder: Schmoock, Helmuth
Büchener Weg 121
D-2058 Lauenburg/Elbe(DE)

(74) Vertreter: Heldt, Gert, Dr. Dipl.-Ing.
Neuer Wall 57 IV
D-2000 Hamburg 36(DE)

(54) Schaltung mit aufgedruckten Leiterbahnen und Verfahren zu deren Herstellung.

(57) Leiterbahnen von elektrischen Schaltungen sind auf eine chemisch metallisierbare Schicht metallisiert, die auf aufgedruckten Kleberbahnen haftet. Als Kleber dienen Haftvermittler, beispielsweise ein reaktives Harzsystem oder Polyurethan. Der Haftvermittler wird auf elektrisch nich leitendes Material aufgedruckt. Eine auf die mit Haftvermittler versehene Seite des Materials aufgepreßte Metallschicht haftet lediglich auf den Leiterbahnen und wird von den übrigen Teilen des Materials wieder abgezogen. Die metallisierbare Schicht kann mit allen Metallen metallisiert werden, die eine gute elektrische Leitfähigkeit aufweisen.

Fig.5

EP 0 045 466 A2

Die Erfindung betrifft eine Schaltung mit aufgedruckten Leiterbahnen, die über einen Haftvermittler auf einer nicht leitenden Platte haften.

Darüber hinaus betrifft die Erfindung ein Verfahren zum Herstellen von gedruckten Schaltungen, deren Leiterbahnen im Wege chemischer Metallisierung auf eine für die Leitung des Stromes vorbestimmte Dicke gebracht werden.

Gedruckte Schaltungen werden auf sehr verschiedene Weise hergestellt. Bei der Aditivtechnik wird eine Aluminiumfolie mit einem Haftvermittler (z.B. bestehend aus Acrylnitril, Butadien, Phenolbasis) beschichtet. Dieses Trägermaterial stellt nach Aufpressen das kernkatalytische Material dar, auf dem chemisch verkupfert werden kann. Das kern-katalytische Material kann auch aufgegossen oder im Tauchverfahren beschichtet werden. Diese Schicht wird bei 140 Grad Celsius getrocknet. Nach dem Zuschneiden und Bohren erfolgt ein Abätzen in Chromschwefelsäure. Anschließend erfolgt der Siebdruck und die weitere chemische Verkupferung.

Bei einem weiteren Verfahren wird ein mit einer Kupferfolie kaschiertes Basismaterial benutzt. Dieses wird im Siebdruck bedruckt. Die dabei freibleibenden Stellen werden abgeätzt.

Nachteile dieser Verfahren sind hohe Kosten, starke Umweltbelastung und hohe Material- und Arbeitsintensität.

Aufgabe der vorliegenden Erfindung ist es daher, das Verfahren der einleitend genannten Art so zu verbessern, daß die Metallisierung ohne kernkatalytisches Material oder komplizierte Ausätzungen vorgenommen werden kann, so daß sich dadurch der Preis für die gedruckten Schaltungen er-heblich vermindern läßt.

2

Diese Aufgabe wird erfindungsgemäß dadurch gelöst, daß der Haftvermittler beim Kaschieren lösungsmittelfrei ist und auf ihm eine chemische metallisierbare Schicht haftet, auf der eine Leiterschicht in der für eine bestimmte Stromstärke notwendigen Dicke chemisch metallisiert ist.

Bei dieser Schaltung ist es nicht notwendig, daß die Platte mit einem kernkatalytischen Material versehen oder ausgeätzt werden muß. Vielmehr werden lediglich die Leiterbahnen mit einer chemisch metallisierbaren Schicht versehen, die die Grundlage darstellt für eine chemisch aufzubringende Metallisierung. Diese Metallisierung kann mit jedem Metall hergestellt werden, das im Wege chemischer Metallisierung übertragbar ist. Unabhängig von der Auswahl eines für die Herstellung bestimmter Leiterbahnen notwendigen Metalls kann also die chemisch metallisierbare Schicht auf die Kleberbahnen aufgebracht werden. Die auf diese Weise herstellbare Schaltung ist billig sowohl hinsichtlich der Bearbeitung als auch bezüglich der zu benutzenden Grundstoffe.

Die bisher verwendeten Verfahren zum Herstellen von gedruckten Schaltungen machten relativ komplizierte und teuere Verfahrensschritte erforderlich. Insbesondere stellte sich die Herstellung des kernkatalytischen Basismaterials als ein teurer Einzelschritt heraus.

Weitere Aufgabe der Erfindung ist es daher, das Verfahren der einleitend genannten Art so zu verbessern, daß die gedruckte Schaltung mit kleinstem Kostenaufwand auch bei kleinen Serien sehr genau hergestellt werden kann.

Diese Aufgabe wird erfindungsgemäß dadurch gelöst, daß den Leiterbahnen entsprechende Kleberbahnen aus einem Kleber, der beim Kaschieren lösungsmittelfrei ist, auf ein elektrisch nicht leitendes Material aufgedruckt werden, eine chemisch metallisierbare Schicht auf das Material aufgepreßt und nach dem Aushärten des Klebers die chemisch metallisierbare Schicht von dem Material abgehoben und dabei ihre auf den Kleberbahnen haftenden Teile als Grundierung zur chemischen Metallisierung aus ihr herausgetrennt werden und auf diese Grundierung die erforderliche Metalldicke chemisch metallisiert wird.

Zur Vorbehandlung der Platten bedarf es nur einer Entfettung. Die kleinsten Abstände zwischen den herzustellenden Leiterbahnen und deren Feinheiten sind bestimmt von dem jeweils ausgewählten Druckverfahren.

Die chemische Metallisierung der Kleberbahnen mit Hilfe einer chemisch metallisierenden Schicht kann in genau einzuhaltenden Schichtdicken geschehen. Diese Schichtdicke ist sehr dünn (1oo - 4oo Angström) und kommt daher mit einem kleinen Bedarf chemisch metallisierbarer Werkstoffe aus. Auf diese Weise ist es möglich, auch teure Werkstoffe, beispielsweise Edelmetalle oder wertvolle seltene Erden zu verwenden, auf denen sich schließlich die Leiterbahnen im Wege der chemischen Metallisierung gut ablagern.

Weitere Einzelheiten der Erfindung ergeben sich aus der nachfolgenden ausführlichen Beschreibung und den beigefügten Zeichnungen, in denen eine bevorzugte Ausführungsform der Erfindung beispielsweise veranschaulicht ist.

In den Zeichnungen zeigen:

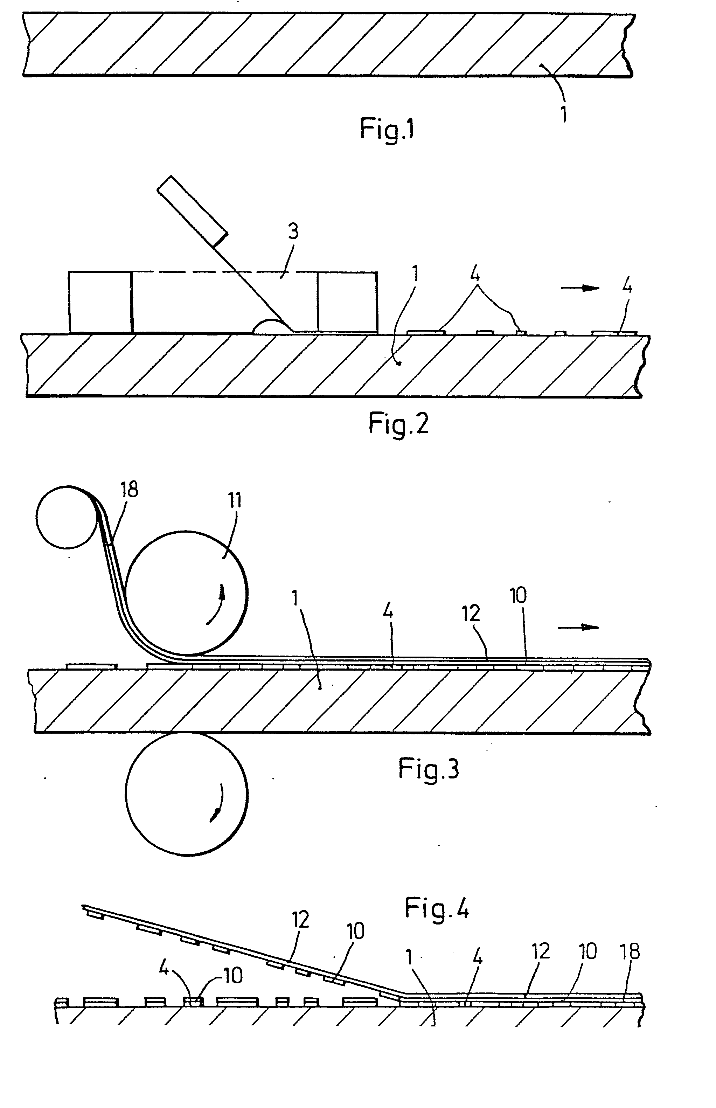

Fig. 1    einen Querschnitt durch eine unbehandelte,
          entfettete Leiterplatte,

Fig. 2    einen Querschnitt durch eine Leiterplatte mit
          aufgebrachten Kleberbahnen,

Fig. 3    einen Querschnitt durch eine Leiterplatte mit
          einer aufgepreßten Metallschicht und Trägerfolie,

Fig. 4    einen Querschnitt durch eine Leiterplatte mit
          teils abgehobener Folienbahn,

Fig. 5    eine schematische Darstellung einer Anlage
          zur Herstellung von gedruckten Schaltungen.

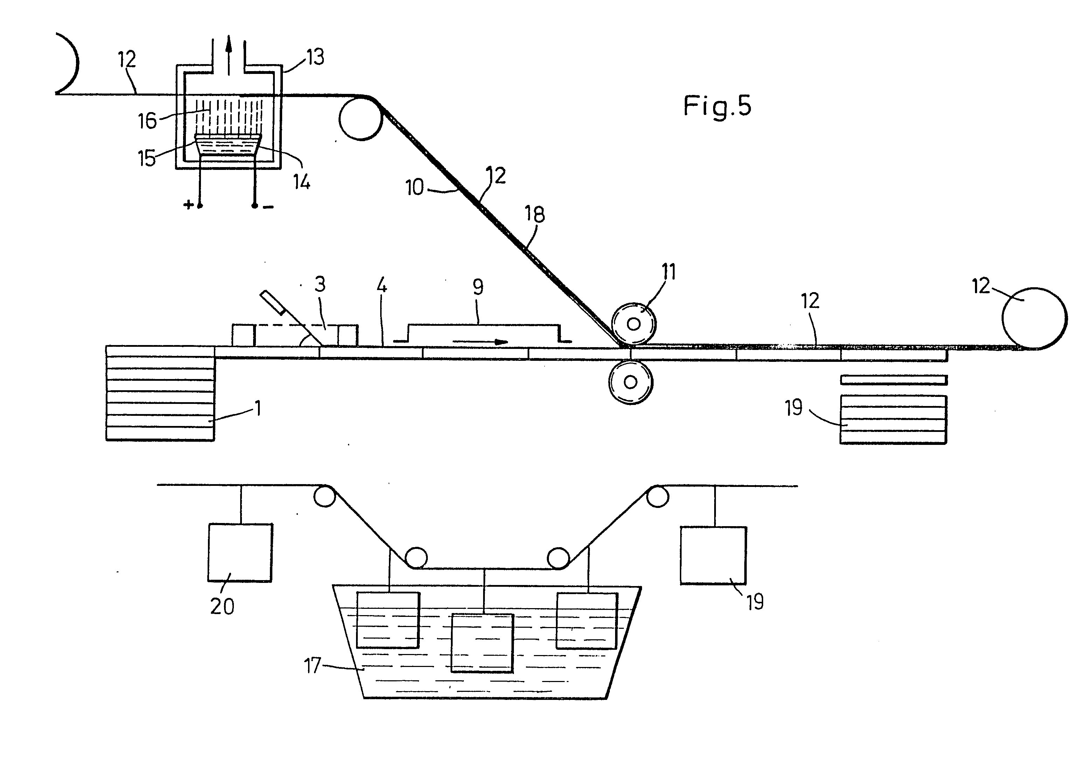

Das erfindungsgemäße Verfahren wird zweckmäßigerweise
auf einer Anlage gemäß Fig. 5 durchgeführt. In einem
Vorratsbehälter ist das Material 1, insbesondere Platten
in einem Stapel, untergebracht, auf das Leiterbahnen zum
Zwecke der Herstellung gedruckter Schaltungen aufgebracht werden sollen. Statt Platten kann auch rollbares
Material 1 verwendet werden.

Das Material 1 wird in einem Druckwerk 3 mit Kleberbahnen 4 bedruckt. Dabei ist Anwendung des Siebdruckverfahrens oder des Tiefdruckes möglich.

Als Kleber wird im Regelfall ein Trockenkaschierkleber
verwendet, der beim Kaschieren lösungsmittelfrei sein
muß. Zur sorgfältigen Trocknung des Klebers ist im Anschluß an das Druckwerk 3 eine Trockenstation 9 vorgesehen, in der sämtliche Lösungsmittelanteile des Klebers aus den Kleberbahnen 4 herausgetrocknet werden. Es
können auch lösungsmittelfreie Klebstoffe verwendet
werden.

Auf die lösungsmittelfreien Kleberbahnen 4 wird eine
Schichtstoffkombination 18 bestehend aus einer Metall-

5

schicht 1o und einem Träger 12 aufgebracht, die mit
Hilfe einer Walzenkombination 11 auf die Kleberbahnen
4 gepreßt wird. Der Träger 12 wird in einer Bedampfungsstation 13 mit der Metallschicht 1o bedampft.
Zu diesem Zwecke ist in der Bedampfungsstation 13 eine
Heizung 14 vorgesehen, die ein Metallbad 15 so hoch erhitzt, daß unter dem Einfluß eines in der Bedampfungsstation 13 herrschenden Vakuums und eines elektrischen
Feldes Metallionen 16 in Richtung auf den durch die Bedampfungsstation 13 hindurchlaufenden Träger 12 aufsteigen und sich an diesem niederschlagen.

Die auf diese Weise hergestellte Schichtstoffkombination 18 wird mit ihrer metallisierten Seite in der
Walzenkombination 11 so auf die Kleberbahnen 4 gepreßt,
daß die Metallschicht 1o an allen Seiten, an denen sie
mit den Kleberbahnen 4 in Berührung kommt, mit diesen
verklebt. Die Walzenkombination 11 kann zu diesem
Zwecke beheizt sein.

In dem Verbund von Material 1 mit der Schichtstoffkombination 18 härtet der Kleber aus, nachdem er mit Hilfe
der Walzenkombination 11 verpreßt worden ist. Nach dem
Aushärten haftet die Metallschicht 1o fest auf den
Kleberbahnen 4. Diese Haftung ist so fest, daß beim Abziehen des Trägers 12 die mit den Kleberbahnen 4 verbundenen Teile der Metallschicht 1o auf dem Material 1
haften. Die Adhäsion der Metallschicht 1o ist viel
größer als die Kohäsion des Metalles, so daß nur an den
Kleberbahnen 4 das Metall 1o scharfkantig haften bleibt.

Nach dem Aushärten des Klebers kann der Träger 12 problemlos mit der noch an ihm haftenden restlichen Metallschicht 1o vom Material 1 gelöst werden. Nach dem Abheben des Trägers 12 sind vorbehandelte Leiterplatten

6

19 entstanden, die an den Stellen mit einer Metallschicht 1o versehen sind, an denen vorher eine Kleberbahn 4 aufgedruckt wurde. Die auf diese Weise mit einer
Metallschicht versehenen vorbehandelten Leiterplatten
19 werden nunmehr durch ein Bad 17 gelenkt, in dem eine
weitere chemische Metallisierung der Metallschicht 1o
stattfindet, die auf den vorbehandelten Leiterplatten
19 haftet. Diese chemiche Metallisierung verläuft in
bereits vorbekannter Weise. Dadurch erhalten die Leiterbahnen der fertigen Leiterplatte 2o eine der jeweils
benötigten Stromstärke angepaßte Dicke. Statt einer
Metallschicht 1o kann auch eine chemisch metallisierbare Schicht beliebiger Provenienz auf den Träger 12
aufgetragen und von diesem auf die Kleberbahnen 4
übertragen werden.

Die Kleberbahnen 4 können mit einem Haftvermittler
hergestellt werden, der einem reaktiven Harzsystem angehört. Beispielsweise ist es denkbar, als Haftvermittler ein Polyurethan zu verwenden. Dieser Haftvermittler
kann sowohl luftfeuchtigkeitshärtend als auch unter dem
Einfluß eines Elektronenstrahls härtend ausgebildet
sein. Schließlich ist es möglich, einen Haftvermittler
zu verwenden, der unter dem Einfluß von ultraviolettem
Licht trocknet. Auch ist es denkbar, den Haftvermittler
als ein Mehrkomponentensystem herzustellen. Dabei kann
ein isonathaltiges Harz Verwendung finden. Es ist aber
auch möglich, ein aushärtendes Epoxitharz zu verwenden.
Auch ein Acrylharz-System kann als Haftvermittler Anwendung finden.

Zur Herstellung der chemisch metallisierbaren Schicht
können Nichteisenmetalle Verwendung finden. So ist es
denkbar, die chemisch metallisierbare Schicht aus Kupfer oder Nickel herzustellen. Darüber hinaus kann die chemisch metallisierbare Schicht aber auch aus einem Edelmetall bestehen. Insbesondere ist an chemisch metallisierbare Schichten aus Gold bzw. Silber zu denken. Auch Elemente aus der Gruppe der seltenen Erden die eine chemische Metallisierung ermöglichen, können benutzt werden.

Das Material 1 kann als eine Platte ausgebildet sein. Diese Platte kann ein Phenolharz sein. Es ist aber auch denkbar, die Platte aus einem Papier, aus einem Epoxit-Papier, Phenolharz-Papier oder einem Epoxit-Gewebe herzustellen. Darüber hinaus haben sich Melaninharze bewährt. Außerdem können auch Polyester, Polyimid, Polycarbonat und Polysulfan als Werkstoffe für das Material 1 verwendet werden. Es können auch billige Papiere Verwendung finden, die beschichtet oder laminiert sind entweder mit einem Polyester, einem Polyimid, einem Polycarbonat oder Polysulfan.

Die Kleberbahnen 4 können im Siebdruckverfahren oder im Tiefdruckverfahren auf das Material 1 beispielsweise die Leiterplatte aufgebracht werden. Das Siebdruckverfahren hat den Vorzug billiger und leichter Herstellung der Kleberbahnen 4.

Vor dem Aufdampfen der chemisch metallisierbaren Schicht auf den Träger 12 ist es möglich, den Träger 12 zunächst mit einer Trennschicht zu versehen. Diese Trennschicht erleichtert das Ablösen der chemisch metallisierbaren Schicht von dem Träger 12. Andererseits muß die Trennschicht so beschaffen sein, daß sie auf keinen Fall mit der chemisch metallisierbaren Schicht haftet. Diese muß vielmehr einwandfrei sauber sein, damit die weitere Metallisierung im chemischen Metallisierungsbad 17 ohne Schwierigkeiten vollzogen werden kann. Als Trennschicht kann ein mit dem Träger 12 fest verbundenes Wachs Verwendung finden. Andererseits ist es möglich, die Trennschicht aus einem Silikon aufzubauen, das fest auf dem Träger 12 haftet. Auch ein Trennlack kann Anwendung finden, der sich besser von der chemisch metallisierbaren Schicht als von dem Träger 12 löst.

Eine entsprechende Auswahl des Trägers 12 ist zweckmäßig. Als Material für den Träger kommt Polypropylen, Polyester oder Polycarbonat in Betracht.

Das Beschichten der Kleberbahnen 4 mit einer chemisch metallisierbaren Schicht kann auch mit Hilfe des bereits bekannten sputtering-Verfahrens erfolgen.

9

Patentansprüche:

1. Schaltung mit aufgedruckten Leiterbahnen, die über einen Haftvermittler auf einer nicht leitenden Platte haften, dadurch gekennzeichnet, daß der Haftvermittler beim Kaschieren lösungsmittelfrei ist und auf ihm eine chemisch metallisierbare Schicht (1o) haftet, auf der eine Leiterschicht in der für eine bestimmte Stromstärke notwendigen Dicke chemisch metallisiert ist.

2. Schaltung nach Anspruch 1, dadurch gekennzeichnet, daß als Haftvermittler ein reaktives Harzsystem vorgesehen ist.

3. Schaltung nach Anspruch 2, dadurch gekennzeichnet, daß als Haftvermittler ein Polyurethan vorgesehen ist.

4. Schaltung nach Anspruch 1 bis 3, dadurch gekennzeichnet, daß der Haftvermittler luftfeuchtigkeitshärtend ist.

5. Schaltung nach Anspruch 1 bis 3, dadurch gekennzeichnet, daß der Haftvermittler elektronenstrahlhärtend ist.

6. Schaltung nach Anspruch 1 bis 3, dadurch gekennzeichnet, daß der Haftvermittler unter dem Einfluß von ultraviolettem Licht trocknend ist.

7. Schaltung nach Anspruch 1 und 2, dadurch gekennzeichnet, daß der Haftvermittler aus einem Mehrkomponentensystem besteht.

8. Schaltung nach Anspruch 1 und 2, dadurch gekennzeichnet, daß der Haftvermittler ein isonathaltiges Harz ist.

9. Schaltung nach Anspruch 1 und 2, dadurch gekennzeichnet, daß der Haftvermittler ein aushärtendes Epoxitharz ist.

1o. Schaltung nach Anspruch 1 und 2, dadurch gekennzeichnet, daß der Haftvermittler ein Acrylharz-System ist.

11. Schaltung nach Anspruch 1 bis 1o, dadurch gekennzeichnet, daß die chemisch metallisierbare Schicht aus einem Nichteisen-Metall besteht.

12. Schaltung nach Anspruch 1 bis 11, dadurch gekennzeichnet, daß die chemisch metallisierbare Schicht aus Kupfer besteht.

13. Schaltung nach Anspruch 1 bis 11, dadurch gekennzeichnet, daß die chemisch metallisierbare Schicht aus Nickel besteht.

14. Schaltung nach Anspruch 1 bis 1O, dadurch gekennzeichnet, daß die chemisch metallisierbare Schicht aus einem Edelmetall besteht.

15. Schaltung nach Anspruch 14, dadurch gekennzeichnet, daß die chemisch metallisierbare Schicht aus Gold besteht.

16. Schaltung nach Anspruch 14 und 15, dadurch gekennzeichnet, daß die chemisch metallisierbare Schicht aus Silber besteht.

17. Schaltung nach Anspruch 14 und 15, dadurch gekennzeichnet, daß die chemisch metallisierbare Schicht aus Elementen der seltenen Erden besteht.

11

18. Schaltung nach Anspruch 1 bis 17, dadurch gekennzeichnet, daß für die Platten ein Material (1) aus einem Phenolharz verwendet wird.

19. Schaltung nach Anspruch 1 bis 17, dadurch gekennzeichnet, daß das Material (1) aus Papier besteht.

20. Schaltung nach Anspruch 1 bis 17, dadurch gekennzeichnet, daß die Platte aus einem Epoxit-Papier besteht.

21. Schaltung nach Anspruch 1 bis 17, dadurch gekennzeichnet, daß das Material (1) aus einem Epoxit-Gewebe besteht.

22. Schaltung nach Anspruch 1 bis 17, dadurch gekennzeichnet, daß das Material (1) aus einem Phenolharz-Papier besteht.

23. Schaltung nach Anspruch 1 bis 17, dadurch gekennzeichnet, daß das Material (1) aus einem Melaminharz besteht.

24. Schaltung nach Anspruch 1 bis 18, dadurch gekennzeichnet, daß das Material (1) aus einem Polyester besteht.

25. Schaltung nach Anspruch 1 bis 18, dadurch gekennzeichnet, daß das Material (1) aus einem Polyimid besteht.

26. Schaltung nach Anspruch 1 bis 18, dadurch gekennzeichnet, daß das Material (1) aus einem Polycarbonat besteht.

12

27. Schaltung nach Anspruch 1 bis 18, dadurch gekennzeichnet, daß das Material (1) aus einem Polysulfan besteht.

28. Schaltung nach Anspruch 19, dadurch gekennzeichnet, daß das Material (1) aus einem Papier mit einer Beschichtung aus Polyester besteht.

29. Schaltung nach Anspruch 19, dadurch gekennzeichnet, daß das Material (1) aus einem Papier mit einer Beschichtung aus Polyimid besteht.

3o. Schaltung nach Anspruch 19, dadurch gekennzeichnet, daß das Material (1) aus einem Papier mit einer Beschichtung aus Polycarbonat besteht.

31. Schaltung nach Anspruch 19, dadurch gekennzeichnet, daß das Material 1 aus einem Papier mit einer Beschichtung aus Polysulfan besteht.

32. Verfahren zum Herstellen von gedruckten Schaltungen gemäß Ansprüchen 1 bis 31, deren Leiterbahnen im Wege chemischer Metallisierung auf eine für die Leitung des Stromes vorbestimmte Dicke gebracht werden, dadruch gekennzeichnet, daß den Leiterbahnen entsprechende Kleber bahnen (4) aus einem Kleber, der beim Kaschieren lösungsmittelfrei ist, auf ein elektrisch nicht leitendes Material (1) aufgedruckt werden, eine chemisch metallisierbare Schicht auf das Material (1) aufgepreßt und nach dem Aushärten des Klebers die chemisch metallisierbare Schicht von dem Material (1) abgehoben und dabei ihre auf den Kleberbahnen (4) haftenden Teile als Grundierung zur chemischen Metallisierung aus ihr herausgetrennt werden und auf diese Grundierung die erforderliche Metalldicke chemisch metallisiert wird.

33. Verfahren nach Anspruch 32, dadurch gekennzeichnet, daß die Kleberbahn (4) im Siebdruck auf das Material (1) aufgedruckt wird.

34. Verfahren nach Anspruch 32, dadurch gekennzeichnet, daß die Kleberbahnen (4) im Tiefdruck auf das Material (1) aufgedruckt werden.

35. Verfahren nach Anspruch 32 bis 34, dadurch gekennzeichnet, daß die chemisch metallisierbare Schicht auf einen Träger (12) aufgedampft wird, dieser mit seiner bedampften Seite auf die Kleberbahnen (4) aufgepreßt wird und nach dem Aushärten des Klebers bis auf die auf den Kleberbahnen (4) haftende chemisch metallisierbare Schicht wieder von der Oberfläche des Materials (1) entfernt wird.

36. Verfahren nach Anspruch 32 bis 35, dadurch gekennzeichnet, daß auf den Träger (12) vor dem Aufdampfen der chemisch metallisierbaren Schicht eine Trennschicht aufgebracht wird, die nach dem Entfernen des Trägers (12) von den auf den Klebebahnen (4) haftenden chemisch metallisierten Schichten auf dem Träger (12) haftet.

37. Verfahren nach Anspruch 32 bis 36, dadurch gekennzeichnet, daß die Trennschicht aus einem Wachs besteht.

38. Verfahren nach Anspruch 32 bis 36, dadurch gekennzeichnet, daß die Trennschicht aus einem Silikon besteht.

39. Verfahren nach Anspruch 32 bis 36, dadurch gekennzeichnet, daß die Trennschicht aus einem auf den Träger (12) aufzubringenden Trennlack besteht.

40. Verfahren nach Anspruch 32 bis 39, dadurch gekennzeichnet, daß der Träger (12) aus einem Polypropylen besteht.

41. Verfahren nach Anspruch 32 bis 39, dadurch gekennzeichnet, daß der Träger (12) aus einem Polyester besteht

42. Verfahren nach Anspruch 32 bis 39, dadurch gekennzeichnet, daß der Träger (12) aus einem Polycarbonat besteht.

1/2

Fig.1

Fig.2

Fig.3

Fig.4

Fig.5

0045466